# EUROPEAN PATENT SPECIFICATION

(11) **EP 3 145 288 B1**
(45) Date of publication and mention of the grant of the patent: **29.07.2020**
(21) Application number: 15185935.2
(22) Date of filing: 18.09.2015
(51) Int. Cl.: H05K 7/20, G02F 1/13357

(54) **A PREFERRED PACKAGING SCHEME FOR TELEVISIONS AND DISPLAY SYSTEMS**
BEVORZUGTES VERPACKUNGSSCHEMA FÜR FERNSEH- UND ANZEIGESYSTEME
SCHÉMA D'EMBALLAGE PRÉFÉRÉ POUR DES TÉLÉVISIONS ET DES SYSTÈMES D'AFFICHAGE

(43) Date of publication of application: 22.03.2017
(73) Proprietor: Vestel Elektronik Sanayi ve Ticaret A.S., 45030 Manisa (TR)
(72) Inventor: Karsli, Kivanc, 45030 Manisa (TR); Arik, Mehmet, Istanbul (TR)
(74) Representative: Ascherl, Andreas

(56) References cited:
- WO-A1-2007/037605
- WO-A1-2015/074287
- CN-A- 101 556 008
- KR-A- 20080 005 759
- US-A1- 2006 292 461
- US-A1- 2007 236 957
- US-A1- 2015 212 257

## Description

### Technical Field

Present invention is related to display devices such as displays, TVs, laptops and smart mobile devices which use lighting units.

### Prior Art

Nowadays, usage of LEDs as lighting units for electronic devices (such as using LEDs as backlight units at televisions, monitors, tablets etc.) becomes more common because of their low power consumption and small sizes. Although the power consumption levels of typical LEDs are relatively small, they produce considerable amount of heat. In order to achieve desired luminescence values, LEDs are driven with high currents. As a result, heat generation of a single LED may exceed 1-1.5 W. If LEDs are not cooled enough, the generated heat may harm LEDs as well as other components of the electronic device. Therefore, especially cooling of the backlight units of the display devices has utmost importance.

Document KR20080005759A discloses a display device having a light source board which is formed as Flexible Printed Circuit or PCB. The light source is arranged in a corner of the display. The light source board is aligned with respect to an edge of the display. Furthermore, the light source board is adhered to a bottom frame.

In order to provide cooling to the backlight units, different cooling systems are used in the art. In the prior art, mainly two types of the cooling systems are used for the cooling operations, namely, active cooling systems and passive cooling systems. In the active cooling systems, as disclosed in the document EP2615521A1, fans are used for cooling the backlight units. Such cooling systems usually provide efficient cooling. However, because of the size of the fans, these active cooling systems are not suitable for slim display devices. They also do not meet the conduction heat transfer needs from backlighting units.

In passive cooling systems, heat generated by the backlight unit is dissipated through heat sinks. Because of their large size and relatively high thermal conductivity, chassis of the display devices are used as heat sinks. Since these passive cooling systems do not require relatively thick additional materials (such as fan), passive cooling systems are suitable to be used in the slim display devices. However, conventional passive cooling systems may not be enough for cooling the backlight units efficiently.

### Object of the Invention

The main object of the present application is to provide an electronic device which use cooling system for the lighting unit.

Another aim of the present application is to provide an electronic device with an efficient cooling.

Another aim of the present application is to provide a slim electronic device.

### Brief Description of the Invention

With the present invention, an electronic device with a number of preferred cooling technologies is provided. Said electronic device comprises, at least one light source as backlight unit; at least one chassis; and at least one heat dissipation plate, wherein said light source (either LED or OLED) is placed on said heat dissipation plate, heat dissipation plate is in connected to said chassis so as to dissipate the heat generated by light source through the chassis and thermal conductivity of the heat dissipation plate is higher than a typical metal substrate (eg. 200 W/mK).

According to the electronic device of the present invention, heat generated by at least one light source is efficiently dissipated using heat dissipation plate and chassis. Therefore, efficient cooling is provided without increasing the size of the electronic device. According to the invention, the heat dissipation plate can be a thermal pyrolytic graphite plate, a graphene type spreader, a heat pipe or a vapor chamber. Further, the heat dissipation plate can extend along one edge of the display device.

According to an embodiment of the invention, the light source comprises at least one light board. In addition, at least one additional heat sink can be provided, which is located between the heat dissipation plate and the chassis. In particular the heat sink can be in the form of a plate, wherein the thermal conductivity is between 100 and 500 W/m-K.

According to a further embodiment of the invention, the heat dissipation plate is placed in direct contact with the chassis and in particular the heat dissipation plate can be embedded within a housing of the chassis or within the chassis itself.

### Description of Drawings

Figure 1 shows an exemplary embodiment of the electronic device of the present invention
Figure 2 shows a cooling system used in the electronic device of the present invention.
Figure 3 shows another cooling system used in the electronic device of the present invention.
Figure 4 shows another cooling system used in the electronic device of the present invention.

| | |
|---|---|
| Electronic device | (D) |
| Light guiding plate | (D1) |
| Light source | (1) |
| Light board | (2) |
| Heat dissipation plate | (3) |
| Chassis | (4) |
| Additional heat sink | (5) |
| Thermal interface material | (6) |

### Detailed Description of the Invention

Lighting units of the electronic devices (such as high power lightening systems or backlight units of televisions, monitors, tablets etc.) produce considerable amount of heat, which may harm the lightening unit itself or any other component of the electronic device. In order to dissipate the heat produced by the lightening units, cooling systems are used. Active cooling systems, which uses fans to cool backlight, provides efficient cooling whereas they are not appropriate for slim cooling devices because of their sizes. Conventional passive cooling systems, which use chassis of electronic device as heat sink, are suitable for slim cooling devices. However, passive cooling systems may not be enough for cooling the backlight unit efficiently. Therefore, according to the present invention, an electronic device with efficient cooling is provided.

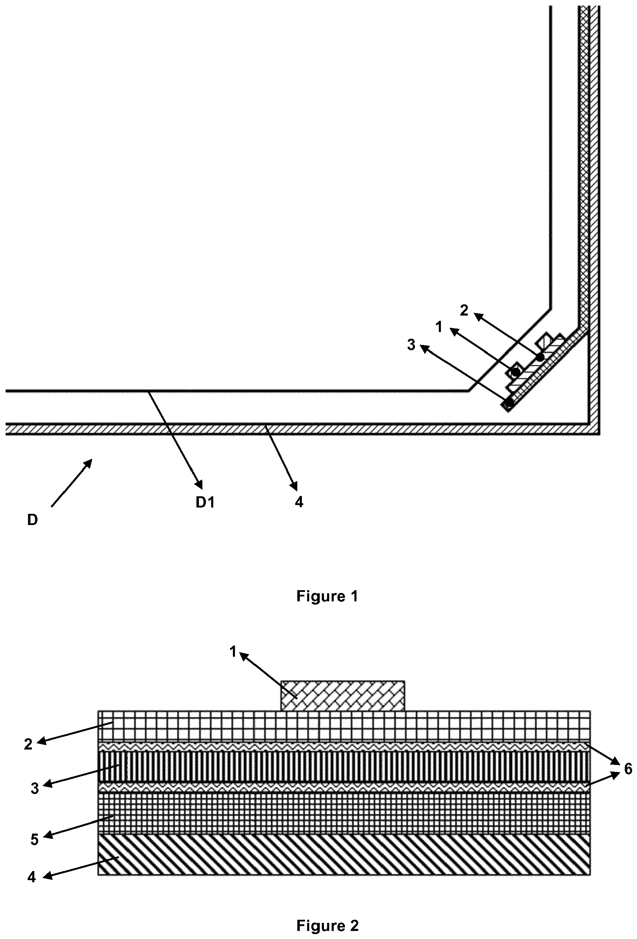

Exemplary embodiments of the cooling system of the present invention are given in figures 1-4. Electronic device of the present invention comprises at least one light source (1) (such as LED or OLED) as a lightening unit (such as backlight unit), at least one chassis (4) and at least one heat dissipation plate (3), wherein said light source (1) is placed on said heat dissipation plate (3), wherein the heat dissipation plate (3) is in connected to said chassis (4) so as to dissipate the heat generated by light source (1) through the chassis (4) and thermal conductivity of the heat dissipation plate (3) is higher than 200 W/mK. Said heat dissipation plate (3) may be a diomand (> 600 W/m-K), a thermal pyrolitic graphite plate (>1500 W/m-K), a grapheme type spreader or heat pipe or a vapor chamber. According to electronic device (D) of the present invention, heat generated by the light source (1) is firstly dissipated through heat dissipation plate (3), thermal conductivity of which is relatively high. Then, said heat is transferred to chassis (4), which occupies higher space for dissipating the heat but has less thermal conductivity as compared to the heat dissipation plate (3). Therefore, thanks to the heat dissipation plate (3), heat generated by light source (1) is transferred to the chassis more rapidly and more uniformly as compared to the conventional systems. As a result, according to the electronic device (D) of the present invention, efficient cooling is provided without increasing the size of the electronic device (D).

According to the invention, given in the figure 1 electronic device (D) is exampled as a display device. In this embodiment, a light source (1) is placed at the at least one corner of the electronic device (D). In order to distribute the light generated by light source (1) through the electronic device (D), wherein the electronic device (D) comprises at least one light guiding plate (D1). According to this embodiment, the heat dissipation plate (3) extends along one edge (preferably through whole edge) of the electronic device (D).

In a preferred embodiment of the present invention, said light source (1) is in the form of LED. In this embodiment, a light source (1) may comprise at least one light board (2) (such as PCB - printed circuit board) onto which at least one LED is placed. According to this embodiment, said light board (2) may be placed onto the heat dissipation plate (3).

In the invention, shown in figure 2, electronic device (D) comprises at least one additional heat sink (5) located between the heat dissipation plate (3) and the chassis (4). Said additional heat sink (5) may be in the form of a plate, thermal conductivity of which is between 100-500 W/mK. In this embodiment, the size of the heat dissipation plate (3) may be kept smaller, thanks to the additional heat sink (5). In other words, according to this embodiment, the size or amount of heat dissipation plate (3), which is more expensive as compared to the additional heat sink (5), is reduced. Therefore, the costs of the electronic device (D) are reduced without decreasing the cooling efficiency.

In a preferred embodiment of the present invention, electronic device (D) comprises thermal interface material (6) (such as thermal paste) in order to increase thermal conductivity between different components. Said thermal interface material (6) may be placed between light board (2) and the heat dissipation plate (3), between heat dissipation plate (3) and additional heat sink (5), between heat dissipation plate (3) and chassis (4) or between additional heat sink (5) and chassis (4).

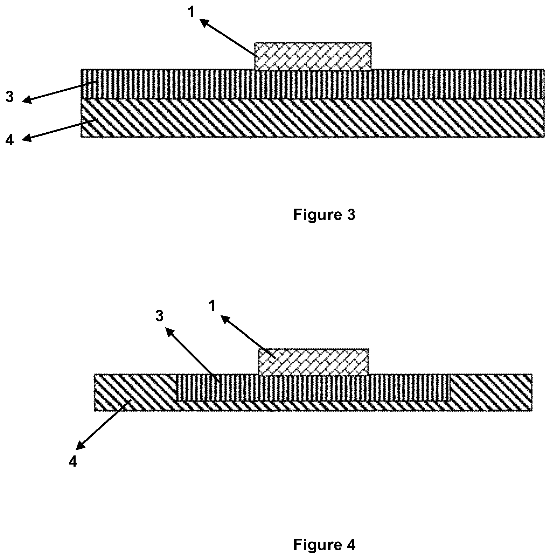

In another exemplary embodiment of the present invention, shown in figures 3 and 4, light source (1) is directly placed onto the heat dissipation plate (3). In this embodiment, heat dissipation plate (3) may be placed onto the chassis (4) or may be placed inside a housing of the chassis (4) and in particular the heat dissipation plate (3) is embedded within a housing of the chassis (4).

According to the electronic device (D) of the present invention, heat generated by at least one light source (1) is efficiently dissipated using heat dissipation plate (3) and chassis (4). Therefore, efficient cooling is provided without increasing the size of the electronic device (D).

## Claims

1. Display device (D) comprising at least one light source (1) as lighting unit and at least one chassis (4), comprising;
- at least one heat dissipation plate (3), wherein said light source (1) is in communication for heat transfer with said heat dissipation plate (3), wherein the heat dissipation plate (3) is connected to said chassis (4) so as to dissipate the heat generated by the light source (1) through the chassis (4), said light source (1) is placed at the at least one corner of the display device (D), **characterized in that**: the thermal conductivity of the heat dissipation plate (3) is higher than 200W/mk, wherein said heat dissipation plate (3) extends along one edge of the
display device (D),
and wherein at least one additional heat sink (5) is located between the heat
dissipation plate (3) and the chassis (4).

2. A display device (D) according to claim 1, **characterized in that** said heat dissipation plate (3) is a thermal pyrolitic graphite plate.

3. A display device (D) according to claim 1, **characterized in that** said heat dissipation plate (3) is a graphene type spreader.

4. A display device (D) according to claim 1, **characterized in that** said heat dissipation plate (3) is a heat pipe or a vapor chamber.

5. A display device (D) according to claim 1, **characterized in that** said light source (1) is in the form of LED or OLED.

6. A display device (D) according to at least one of the claims 1 to 5, **characterized in that** said light source (1) comprises at least one light board (2).

7. A display device (D) according to claim 1 **characterized in that** said additional heat sink (5) is in the form of a plate, thermal conductivity of which is between 100-500 W/mK.

8. A display device (D) according to at least one of the claims 1 to 7, **characterized by** further comprising a thermal interface material (6).

9. A display device (D) according to at least one of the claims 1 to 8, **characterized in that** said light source (1) is directly placed onto the heat dissipation plate (3).

## Patentansprüche

1. Anzeigevorrichtung (D), umfassend mindestens eine Lichtquelle (1) als Beleuchtungseinheit und mindestens ein Chassis (4) umfassend; - mindestens eine Wärmeableitungsplatte (3), wobei die Lichtquelle (1) zur Wärmeübertragung mit der Wärmeableitungsplatte (3) in Verbindung steht, wobei die Wärmeableitungsplatte (3) mit dem Chassis (4) verbunden ist um die von der Lichtquelle (1) erzeugte Wärme über das Chassis (4) abzuleiten,
die Lichtquelle (1) ist an mindestens einer Ecke der Anzeigevorrichtung (D) angeordnet,
**dadurch gekennzeichnet, dass**:
die Wärmeleitfähigkeit der Wärmeableitungsplatte (3) höher als 200 W / mK ist,
wobei sich die Wärmeableitungsplatte (3) entlang einer Kante der Anzeigevorrichtung (D) erstreckt,
und
wobei zumindest ein zusätzlicher Kühlkörper (5) zwischen der Wärmeableitungsplatte (3) und dem Chassis (4) angeordnet ist.

2. Anzeigevorrichtung (D) nach Anspruch 1, **dadurch gekennzeichnet, dass** die Wärmeableitungsplatte (3) eine thermisch pyrolitische Graphitplatte ist.

3. Anzeigevorrichtung (D) nach Anspruch 1, **dadurch gekennzeichnet, dass** die Wärmeableitungsplatte (3) ein Verteiler vom Graphen-Typ ist.

4. Anzeigevorrichtung (D) nach Anspruch 1, **dadurch gekennzeichnet, dass** die Wärmeableitungsplatte (3) ein Wärmerohr oder eine Dampfkammer ist.

5. Anzeigevorrichtung (D) nach Anspruch 1, **dadurch gekennzeichnet, dass** die Lichtquelle (1) die Gestalt einer LED oder OLED hat.

6. Anzeigevorrichtung (D) nach mindestens einem der Ansprüche 1 bis 5, **dadurch gekennzeichnet, dass** die Lichtquelle (1) mindestens eine Lichtplatine (2) umfasst.

7. Anzeigevorrichtung (D) nach Anspruch 1, **dadurch gekennzeichnet, dass** der zusätzliche Kühlkörper (5) die Form einer Platte hat, deren thermisch Leitfähigkeit zwischen 100-500W/mK liegt.

8. Anzeigevorrichtung (D) nach mindestens einem der Ansprüche 1 bis 7, **gekennzeichnet durch** ebenfalls aufweisend ein Thermal-Interface Material (6).

9. Anzeigevorrichtung (D) nach mindestens einem der Ansprüche 1 bis 8, **dadurch gekennzeichnet, dass** die Lichtquelle (1) direkt auf der Wärmeableitungsplatte (3) platziert ist.

## Revendications

1. Dispositif d'affichage (D) comprenant au moins une source de lumière (1) comme unité d'éclairage et comprenant au moins un châssis (4) ; - au moins un
une plaque de dissipation de chaleur (3), dans laquelle la source de lumière (1) est adaptée pour être connectée à la
plaque de dissipation de la chaleur (3), dans laquelle la plaque de dissipation de la chaleur (3) est relié au châssis (4) pour dissiper la chaleur générée par la source lumineuse (1) via le châssis (4),
la source lumineuse (1) est située au moins à un coin du dispositif d'affichage (D) ordonné,
caractérisé en cela :
la conductivité thermique de la plaque de dissipation de la chaleur (3) est supérieure à 200 W/mK,
dans lequel la plaque de dissipation de la chaleur (3) s'étend le long d'un bord de l'écran (D),
et
dans lequel au moins un dissipateur thermique supplémentaire (5) est disposé entre les la plaque de dissipation de la chaleur (3) et le châssis (4).

2. Dispositif d'affichage (D) selon la revendication 1, **caractérisé en ce que** le La plaque de dissipation de la chaleur (3) est une plaque de graphite pyrolitique thermique.

3. Dispositif d'affichage (D) selon la revendication 1, **caractérisé en ce que** le la plaque de dissipation de chaleur (3) est un collecteur de type graphène.

4. Dispositif d'affichage (D) selon la revendication 1, **caractérisé en ce que** la plaque de dissipation de la chaleur (3) est un caloduc ou une chambre à vapeur.

5. Dispositif indicateur (D) selon la revendication 1, **caractérisé en ce que** le la source lumineuse (1) a la forme d'une LED ou d'un OLED.

6. Dispositif d'affichage (D) selon au moins l'une des revendications 1 à 5, de sorte **caractérisé en ce que** la source lumineuse (1) comprend au moins un panneau lumineux (2).

7. Dispositif d'affichage (D) selon la revendication 1, **caractérisé en ce que** le dissipateur thermique supplémentaire (5) a la forme d'une plaque dont la conductivité thermique est comprise entre 100-500W/mK.

8. Dispositif d'affichage (D) selon au moins une des revendications 1 à 7, **caractérisé en ce qu'**il comprend également un matériau d'interface thermique (6).

9. Dispositif d'affichage (D) selon au moins une des revendications 1 à 8, **caractérisé en ce que** la source lumineuse (1) est placée directement sur la plaque de dissipation de chaleur (3).
